Europäisches Patentamt

European Patent Office

Office européen des brevets

(11) Publication number : **0 524 741 A1**

# (12) EUROPEAN PATENT APPLICATION

(21) Application number : **92306211.1**

(22) Date of filing : **07.07.92**

(51) Int. Cl.⁵ : **G03F 1/14**

(30) Priority : **12.07.91 US 729259**

(43) Date of publication of application :
**27.01.93 Bulletin 93/04**

(84) Designated Contracting States :
**DE FR GB IT**

(71) Applicant : **MOTOROLA, INC.**
**1303 East Algonquin Road**
**Schaumburg, IL 60196 (US)**

(72) Inventor : **Bukhman, Yefim**
**9809 N. 85th Street**
**Scottsdale, Arizona 85258 (US)**
Inventor : **Keller, Edward M.**
**2052 E. Fremont Drive**
**Tempe, Arizona 85258 (US)**

(74) Representative : **Ibbotson, Harold et al**
**MOTOROLA European Intellectual Property**
**Operations Jays Close Viables Ind. Estate**
**Basingstoke Hants RG22 4PD (GB)**

(54) **Method for improving the resolution of a semiconductor mask.**

(57)    A phase shift mask (24) used for manufacturing semiconductor devices includes a pattern layer (26) that contains the predetermined pattern of a desired semiconductor feature which is formed in a plurality of apertures in the pattern layer (26). A conformal coating (27) is applied to the mask (24) to create a phase shift region (31, 36, 37) within a predetermined distance (29) of each aperture in the pattern layer (26). The conformal coating (27) forms two regions (31, 36, 37) (32) having different thicknesses. The phase of light passing through the thicker or phase shift region (31, 36, 37) is shifted relative to light passing through the thin region (32).

*FIG. 4*    24

## Background of the Invention

The present invention relates, in general, to masks used in manufacturing semiconductors, and more particularly, to a novel phase shift mask.

The increasing requirement for smaller semiconductor devices had previously been limited by the resolution of conventional semiconductor photo masks. Creating a phase shift mask was one method to improve the resolution that could be obtained from conventional semiconductor masks. A typical phase shift mask included phase shift elements that shifted the phase of a portion of light that passed through the mask's apertures. thereby producing a smaller light pattern.

One disadvantage of previous phase shift masks was the phase shift elements that were required. Forming the phase shift elements generally involved covering the mask with a phase shift material, applying a mask to define the phase shift elements, and etching away unwanted portions of the phase shift material. Since the phase shift elements were smaller than the apertures, this new mask had to be carefully aligned to the apertures. The additional deposition, masking, and etching operations not only added additional manufacturing cost, but could also create defects in the phase shift material and in the mask.

Another disadvantage was the difficulty in determining the pattern to be used to create the phase shift elements. In general, only a portion of the apertures received phase shift elements. Consequently, complicated mask generation algorithms were required to determine the placement of the phase shift elements. Often the algorithm did not result in optimum element placement and the result was a minimal improvement in the resolution provided by a conventional mask.

Accordingly, it is desirable to have a phase shift mask that does not have individual phase shift elements, that does not require additional masking and etching operations, that has a phase shift region that is self-aligned to mask apertures, and that has a phase region thickness that is independent of the phase shift material's thickness.

## Summary of the Invention

Briefly stated, the present invention provides a phase shift mask that can be used for manufacturing semiconductors. The mask has a pattern layer that contains the predetermined pattern of a desired semiconductor feature which is formed in a plurality of apertures in the pattern layer. A conformal coating is applied to the mask in order to form a phase shift region within a predetermined distance of each aperture. The conformal coating forms two regions having different thicknesses. The phase of light passing through the thicker or phase shift region is shifted relative to light passing through the thin region.

As used herein the word(s) "light", either single or plural, mean(s) electromagnetic waves that may be coherent or incoherent and that have wavelengths that may be in the visible or other spectrums.

## Brief Description of the Drawings

FIG. 1 is an enlarged cross sectional portion of a conventional semiconductor mask in accordance with the prior art;

FIG. 2 is the mask of FIG. 1 at a stage in the formation of shift elements;

FIG. 3 is an enlarged cross sectional portion of a prior art phase shift mask;

FIG. 4 is an enlarged cross sectional portion of a phase shift mask in accordance with the present invention;

FIG. 5 is a graph illustrating a light intensity pattern produced by the phase shift mask of FIG. 4 in accordance with the present invention; and

FIG. 6 is a graph illustrating the properties of some phase shift materials in accordance with the present invention.

## Detailed Description of the Drawings

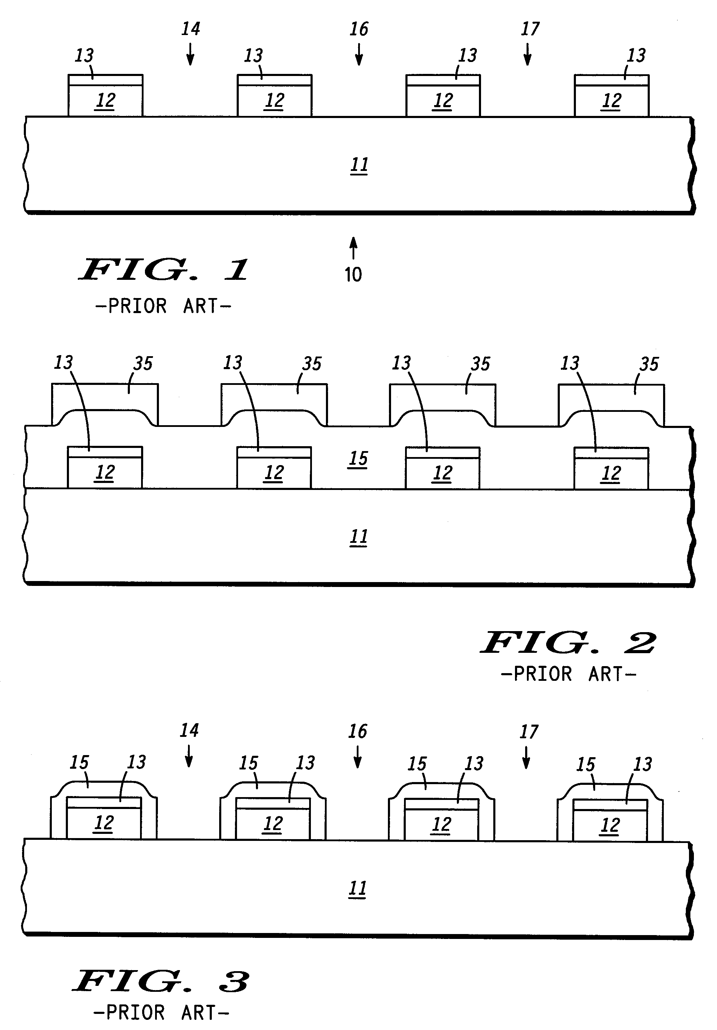

FIG. 1 illustrates a cross-sectional view of a portion of a conventional semiconductor mask 10 to which phase shift elements will be added in accordance to the prior art. Mask 10 includes a pattern layer 12 which contains a predetermined pattern of a desired semiconductor device feature. A glass substrate 11 provides support for a thin layer of chrome that typically is used to create pattern layer 12. In some cases, an anti-reflective coating 13 is applied to pattern 12 to reduce reflections from the chrome. Pattern layer 12 includes a plurality of apertures, such as apertures 14, 16, and 17, through which light passes to form an illuminated pattern in the shape of the desired semiconductor device feature.

Referring to FIG. 2, in accordance to the prior art indium tin oxide is typically used to create a transparent film 15 that covers a conventional mask such as mask 10 of FIG. 1. Transparent film 15 is generally applied by sputtering or other similar techniques. The resulting film 15 has an irregular surface that matches the elevations and openings of pattern layer 12. Masking and etching operations will transform portions of transparent film 15 that are within apertures 14, 16, and 17 into phase shift elements. A photo resist layer is applied to film 15 and formed into an etch mask 35. A pattern for exposing the photo resist layer is formed by modifying the pattern used to form pattern layer 12. Generally, each element and shape of pattern layer 12 is enlarged by some amount to form the pattern for etch mask 35. This is a critical operation that is extremely complicated and is generally performed by a computer algorithm that operates on each section of pattern layer 12. After the pattern is prepared, a mask is created from the pattern, the mask is applied to the layer of photo resist, aligned to pattern layer 12, and exposed to form etch mask 35. Portions of film 15 that are exposed by etch mask 35 are etched completely through to substrate 11. This etch operation is also a critical step. Misalignment of etch mask 35 could result in inadvertent etching of pattern layer 12, or at least in creating phase shift elements that are too narrow to be effective.

FIG. 3 is the prior art mask of FIG. 2 after the etching operation has been completed and etch mask 35 has been removed. The portions of film 15 that remain in apertures 14, 16, and 17 form phase shift elements. The irregular shape of film layer 15 near the top corners of pattern layer 12 result from the non-uniform deposition, e.g. sputtering, of film layer 15 as discussed in FIG. 2.

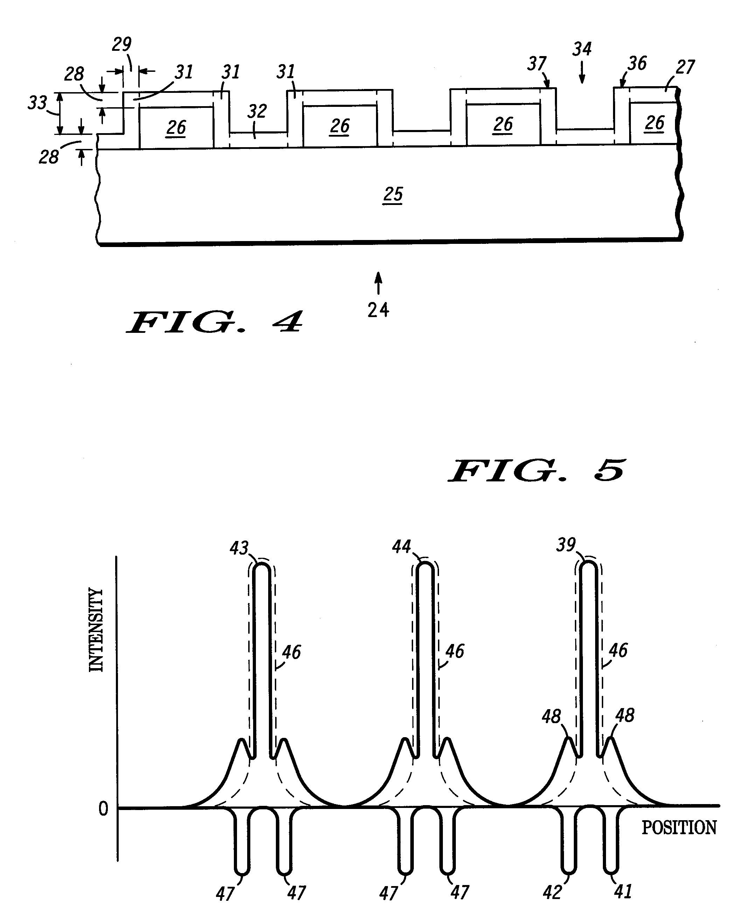

FIG. 4 illustrates a cross sectional portion of a phase shift mask 24 that is suitable for producing fine geometry semiconductor devices in accordance with the present invention. Phase shift mask 24 includes a rigid transparent substrate 25 on which a pattern layer 26 has been formed. A plurality of apertures in pattern layer 26 form a predetermined pattern that is suitable for use in forming a desired semiconductor device feature. In some cases, a low reflectivity layer (not shown) may cover pattern layer 26. In the preferred embodiment, substrate 25 is glass while pattern layer 26 is a layer of chrome. In this preferred embodiment, the glass used for substrate 25, the chrome used for pattern layer 26, and the methods of forming pattern layer 26 on substrate 25 are similar to the techniques used to form conventional mask 10 shown in FIG. 1. Phase shift mask 24 also includes a phase shift layer 27 that covers pattern layer 26 and exposed portions of substrate 25, and has a thickness 28. Phase shift layer 27 is a conformal coating of a material that is applied using conformal thin film deposition methods such as chemical vapor deposition (CVD), plasma enhanced chemical vapor deposition (PECVD), or other similar conformal deposition methods. The material used for phase shift layer 27 has an index of refraction suitable for producing a 180° phase shift as light passes through the material. The phase shift is created by passing light through two different thicknesses of phase shift layer 27. A thin or reference region 32 functions as a reference that permits light to pass through without a phase shift. A thick or phase shift region 31 has a greater thickness than reference region 32. For clarity, the boundaries of phase shift region 31 and reference region 32 are highlighted by dashed lines. The difference in thickness between region 31 and region 32 creates a 180° difference in the phase of light that passes through regions 31 and 32. This thickness difference is formed by the conformal characteristics of the coating that is used for phase shift layer 27. The thickness of phase shift region 31 is equal to thickness 28 of phase shift layer 27 plus the thickness of pattern layer 26, while the thickness of reference region 32 is equal to thickness 28. As a result, the difference in thickness between phase shift region 31 and reference region 32 is the thickness of pattern layer 26, and is referred to as a phase shift thickness 33. Therefore phase shift thickness 33 is determined by the thickness of pattern layer 26 and is independent from thickness 28 of phase shift layer 27.

The conformal characteristics of phase shift layer 27 results in a coating that closely reproduces the topology of the conventional mask to which phase shift layer 27 is applied. These conformal characteristics provides phase shift region 31 with a shape that closely matches the sidewalls of pattern layer 26 and has a clear delineation near the top edges of pattern layer 26. This is an improvement compared to the prior phase shift elements of prior phase shift masks as shown in FIG. 3. Because phase shift layer 27 is a conformal coating, phase shift layer 27 has thickness 28 on exposed portions of substrate 25, on pattern layer 26, and on the sidewalls of pattern layer 26. Consequently, phase shift region 31 has a width 29 that is equal to thickness 28, and is independent from phase shift thickness 33. This ability to control width 29 of phase shift region 31 independently from phase shift thickness 33 is a significant improvement over prior methods of forming a phase shift mask. In addition, forming phase shift region 31 with a single conformal deposition that does not require mask alignments or etching is a further improvement over previous methods of forming phase shift masks.

In order to produce a 180° phase shift in light that passes through a material, the distance (d) that the light must travel through the material is determined by the wavelength of the light and the index of refraction of the material as shown by the equation below:

$$d = \frac{L}{2(n-1)}$$

where;

    d = distance light passes through the material,
    L = wavelength of incident light,
    n = index of refraction of the material.

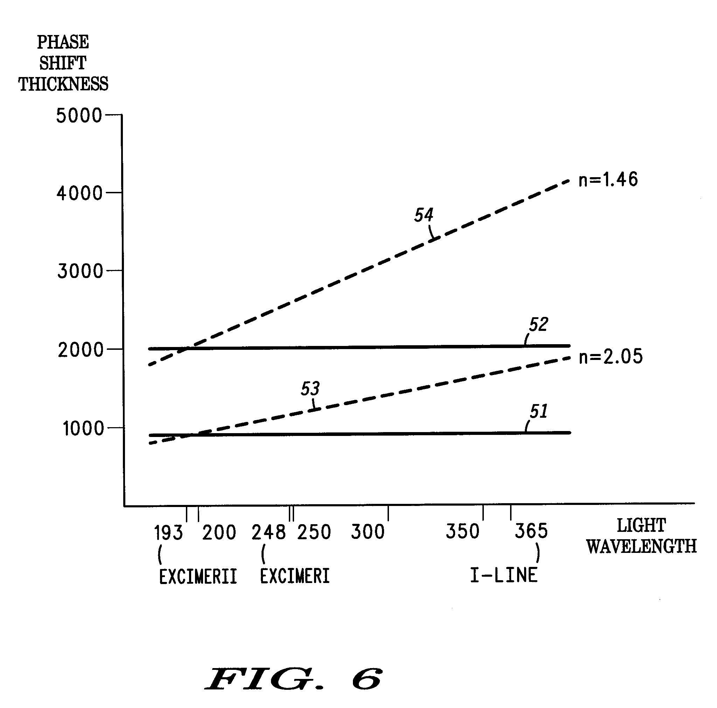

In phase shift mask 24, the distance (d) is equal to phase shift thickness 33. The index of refraction (n) is the index of refraction of the material used for phase shift layer 27. In the preferred embodiment, phase shift layer 27 is silicon nitride ($Si_3N_4$) which has an index of refraction of approximately 2.05. It is important to note that the phase shift equation is independent from thickness 28 of phase shift layer 27. Consequently, the thickness of pattern layer 26 can be varied to provide a value for phase shift thickness 33 that is suitable for a particular wavelength of light and a particular index of refraction, while thickness 28 of phase shift layer 27 can be varied for a desired width 29 of phase shift region 31. Width 29 is typically determined by the smallest aperture on a phase shift mask. Several examples of phase shift layer materials are illustrated hereinafter in FIG. 6.

FIG. 5 is a graph illustrating a light intensity pattern that is produced as light passes through the apertures of phase shift mask 24 that is shown in FIG. 4. Since the graph of FIG. 5 is produced by light transmitted through phase shift mask 24 of FIG. 4, the discussion of FIG. 5 will have references to FIG. 4. The ordinate of FIG. 5 represents the phase and intensity of light that is transmitted through mask 24, and the abscissa represents position relative to mask 24. An in-phase graph 39 represents the distribution of light that is transmitted through a reference region 34 of phase shift mask 24. As light passes through region 34, the light is bent in the area near the corners of pattern layer 26 and is formed into a diffraction pattern as shown by graph 39. The intensity of graph 39 has at least two maximas 48 that reduce the resolution of light passing through region 34. Light passing through a phase shift region 36 and a phase shift region 37 travels a further distance through the material of regions 36 and 37. As a result, the light intensity pattern is attenuated in addition to being shifted 180° as indicated by a graph 41 and a graph 42. Graph 41 results from light passing through phase shift region 36, and graph 42 results from passing through phase shift region 37. The downward excursion of graphs 41 and 42 indicates that a 180° phase shift has occurred. The light that produces graphs 41 and 42 is 180° out of phase with the light that produces graph 39, therefore, the light patterns algebraically add together and produce an interference pattern as illustrated by a corresponding portion of a dashed line 46. In a similar manner, a light intensity graph 43 and a light intensity graph 44 are created by two other reference regions of phase shift mask 24. Corresponding to light intensity graphs 43 and 44, are four shifted light intensity graphs 47 that are produced by four corresponding phase shift regions of phase shift mask 24. The light that produces shifted graphs 47 algebraically adds to the light that produces graphs 43 and 44 resulting in the remaining portions of the interference pattern 46. Consequently, phase shift mask 24 produces a much sharper image and higher resolution than a corresponding conventional mask, and can be manufactured from a conventional mask without additional masking and etching operations.

FIG. 6 is a graph illustrating pattern layer thicknesses that are required for some phase shift layer materials at various wavelengths of light. The abscissa represents light wavelength in nanometers, while the ordinate represents pattern layer or phase shift thickness in angstroms. Also included on the abscissa is the light wavelength emitted by three semiconductor mask exposure systems. An I-line exposure system generally has an emission at a wavelength of 365 nanometers, a krypton fluoride (KrF) Excimer I laser has an emission at approximately 248 nanometers, and an argon fluoride (ArF) Excimer II laser system generally emits light having a wavelength of approximately 193 nanometers. The graph of FIG. 6 provides an easy method to compare the refraction index of phase shift layer materials, to optical system wavelengths and pattern layer thickness. The examples of FIG. 6 illustrate some material combinations that can be utilized to produce a phase shift mask from a conventional semiconductor mask. Other materials and thicknesses can be used for the pattern layer, and other materials can be used for the phase shift layer.

Since chrome is the generally accepted pattern layer material in the semiconductor industry and the currently accepted thickness for such chrome layers is between approximately 900 angstroms and 2000 angstroms, these thicknesses are represented in FIG. 6 by a graph 51 and a graph 52, respectively. For a phase shift layer with a particular index of refraction (n), the phase shift thicknesses (d) required to provide a 180° phase shift are calculated, using the equation of FIG. 4, and the values plotted on the graph of FIG. 6. If the calculated phase shift thickness lies between graphs 51 and 52, a chrome pattern layer of that thickness can be created to provide the desired phase shift layer. A graph 53 illustrates an example of such a calculated pattern layer or phase shift thicknesses for a silicon nitride phase shift layer which has an index of refraction of approximately 2.05. Since graph 53 lies between graphs 51 and 52, a chrome pattern layer thickness can be formed for each of the wavelengths shown in FIG. 6. Therefore, silicon nitride can be used as a phase shift layer material for all of the wavelengths shown in FIG. 6. A graph 54 illustrates similar phase shift thicknesses that are required for a silicon dioxide ($SiO_2$) phase shift layer that has an index of refraction of approximately 1.46. Graph 54 indicates that the particular conditions of the example shown in FIG. 6 limit the use of $SiO_2$ as a phase shift layer to wavelengths below approximately 200 nanometers. Various combinations of nitrogen and oxygen can be used to create a variety of silicon oxynitride ($Si_xO_yN_z$) materials having an index of refraction between the 2.05 value of silicon nitride and the 1.46 value of silicon dioxide. The pattern layer thickness for such materials can be calculated from the equation of FIG. 4 in a similar manner.

By now it should be appreciated that there has been provided a novel way to fabricate a phase shift mask. Covering the pattern layer and substrate of a conventional mask with a conformal coating creates a versatile phase shift layer. The phase shift region thickness that is required to establish the phase shift is independent from the width of the phase shift region. Use of the conformal phase shift layer permits forming a phase shift mask from a conventional mask with a single deposition of a conformal coating. The phase shift region along with the reference region is created without additional etching or masking operations, consequently, no additional mask defects are created while forming the phase shift mask. No complicated algorithms are required to determine a phase shift mask pattern, consequently, the method easily fits into conventional mask making procedures and is compatible with conventional mask making equipment.

While the invention is described with specific preferred embodiments, it is evident that many alternatives and variations will be apparent to those skilled in the semiconductor art. More specifically the invention has been described for a particular mask structure, although the method is directly applicable to other structures, as well as to other pattern layer materials and phase shift layer materials.

## Claims

1. A method of improving the resolution of a semiconductor mask comprising:
   providing a semiconductor mask (24) having a pattern layer (26) with a plurality of apertures which are in a predetermined pattern, wherein each aperture has sidewalls; and
   forming a phase shift region (31, 36, 37) juxtaposed to each sidewall by covering the mask (24) with a conformal coating (27) for the purpose of creating a 180° phase shift in light that passes through the phase shift region (31).

2. The method of claim 1 wherein providing the semiconductor mask (24) having the pattern layer (26) includes providing the semiconductor mask (24) having a chrome pattern layer (26).

3. The method of claim 1 wherein the forming the phase shift region (31, 36, 37) step includes covering the mask (24) with a conformal layer (27) of silicon oxynitride.

4. The method of claim 1 wherein forming the phase shift region (31, 36, 37) includes forming the phase shift region (31, 36, 37) having a width (29) that is approximately equal to a thickness (28) of the conformal coating (27).

5. The method of claim 1 or 4 wherein covering the mask (24) with the conformal coating (27) includes simultaneously forming the phase shift region (31, 36, 37) and an adjacent reference region (32).

6. The method of claim 5 wherein forming the phase shift region (31, 36, 37) includes forming the phase shift region (31, 36, 37) having a thickness that is greater than the adjacent reference region (32).

7. The method of claim 1 wherein the forming the phase shift region (31, 36, 37) step includes applying the conformal coating (27) using a chemical vapor deposition technique.

8. The method of claim 1 wherein the forming the phase shift region (31, 36, 37) step includes applying the conformal coating (27) using a plasma enhanced chemical vapor deposition technique.

9. The method of claim 1 wherein the forming the phase shift region (31, 36, 37) step includes covering the mask (24) with a conformal layer (27) of silicon dioxide.

10. The method of claim 1 wherein the forming the phase shift region (31, 36, 37) step includes covering the mask (24) with a conformal layer (27) of silicon nitride.

**FIG. 1**

-PRIOR ART-

**FIG. 2**

-PRIOR ART-

**FIG. 3**

-PRIOR ART-

**FIG. 4**

**FIG. 5**

FIG. 6

## EUROPEAN SEARCH REPORT

**European Patent Office**

**Application Number**

EP 92 30 6211

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | EP-A-0 489 540 (AMERICAN TELEPHON AND TELEGRAPH COMPANY) * column 7, line 38 - line 54; figure 10 * | 1-10 | G03F1/14 |
| P,X | EP-A-0 475 694 (FUJITSU LIMITED) * column 8, line 12 - column 9, line 55; figures 3A,4 * | 1-10 | |
| P,X | EP-A-0 453 310 (SHARP KABUSHIKI KAISHA) * column 4, line 9 - line 20 * * figures 1C,2C,3C,9 * | 1-10 | |
| A | EP-A-0 401 795 (OKI ELECTRIC INDUSTRY COMPANY LIMITED) * the whole document * | 1-10 | |
| P,A | US-A-5 045 417 (OKAMOTO) * the whole document * | 1-10 | |
| A | PATENT ABSTRACTS OF JAPAN vol. 14, no. 814 (P-1092)14 August 1990 & JP-A-21 40 743 ( HITACHI LTD ) 30 May 1990 * abstract * | 1-10 | **TECHNICAL FIELDS SEARCHED (Int. Cl.5 )** G03F |
| P,X | PATENT ABSTRACTS OF JAPAN vol. 16, no. 146 (E-1188)10 April 1992 & JP-A-40 03 412 ( SHARP CORP ) 8 January 1992 * abstract * | 1-10 | |
| P,A | PATENT ABSTRACTS OF JAPAN vol. 16, no. 019 (P-1300)17 January 1992 & JP-A-32 37 458 ( MITSUBISHI ELECTRIC CORP ) 23 October 1991 * abstract * | 1-10 | |

-----

The present search report has been drawn up for all claims

| Place of search | Date of completion of the search | Examiner |
|---|---|---|
| THE HAGUE | 09 OCTOBER 1992 | BARATHE R. |

EPO FORM 1503 03.82 (P0401)